Europäisches Patentamt

European Patent Office

Office européen des brevets

(11) Publication number: **0 223 787 B1**

# EUROPEAN PATENT SPECIFICATION

(45) Date of publication of patent specification: **18.03.92**

(51) Int. Cl.⁵: **C23C 16/04**, C23C 16/48, H01L 21/285, H01L 21/31

(21) Application number: **86903102.1**

(22) Date of filing: **09.05.86**

(86) International application number:
**PCT/US86/00994**

(87) International publication number:
**WO 86/06755 (20.11.86 86/25)**

(54) SELECTIVE CHEMICAL VAPOR DEPOSITION METHOD AND APPARATUS.

(30) Priority: **10.05.85 US 733445**
**27.12.85 US 813890**

(43) Date of publication of application:
**03.06.87 Bulletin 87/23**

(45) Publication of the grant of the patent:
**18.03.92 Bulletin 92/12**

(84) Designated Contracting States:
**AT BE CH DE FR GB IT LI LU NL SE**

(56) References cited:
**EP-A- 0 135 308**
**US-A- 3 845 738**
**US-A- 3 916 822**
**US-A- 4 496 609**

**IBM Technical Disclosure Bulletin, vol. 15, no. 7, Dec. 1972, (New York, US), J.J. Cuomo et al.: " Chemical vapor deposition by projected ultraviolet patterns ", page 2335, see the whole document.**

(73) Proprietor: **GENERAL ELECTRIC COMPANY**
**1 River Road**
**Schenectady New York 12305(US)**

(72) Inventor: **WILSON, Ronald, Harvey**
**699 St. Mark's Lane**
**Schenectady, NY 12309(US)**
Inventor: **STOLL, Robert, Winston**
**24 Hembold Drive**
**Schenectady, NY 12306(US)**
Inventor: **CALACONE, Michael, Anthony**
**213-7th Avenue**
**Watervliet, NY 12189(US)**

(74) Representative: **Catherine, Alain et al**
**General Electric France Service de Propriété Industrielle 18 Rue Horace Vernet**
**F-92136 Issy-Les-Moulineaux Cedex(FR)**

(74) Representative: **Sieb, Rolf, Dr.**
**General Electric - Deutschland Patentabteilung Praunheimer Landstrasse 50**
**W-6000 Frankfurt/Main(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

**Japanese Journal of Applied Physics, vol. 24, no. 3, part 1, Mar. 1985, ( Tokyo, JP ), J. Takahashi et al.: " UV irradiation effects on chemical vapor deposition of Si02 " pages 274-278 , see the whole document.**

# Description

The present invention relates generally to a chemical vapor deposition apparatus and process. More particularly, it relates to a chemical vapor deposition apparatus characterized by the selective formation of metal films on metal and semiconductor surfaces of a substrate, such as a patterned silicon water, and also a method for its use.

There is a continuous trend in the development of solid state circuitry to reduce the dimensions of devices in integrated circuits and in this way increase the speed of operation and density of the circuitry. As the dimensions of devices on silicon wafers continues to shrink, there is a need to increase the number of layers of conducting lines to interconnect the devices in the circuit. The conducting paths between these layers must be small, and consequently become very difficult to fill. An improved method for filling these openings with conductors is needed.

A solution to this problem would be to grow a metal selectively on the conductor and semiconductor surfaces by chemical vapor deposition. However, to deposit thick films of metals, one must use a reducing atmosphere.

For example, to obtain tungsten films greater than 50 nm (500 Angstroms) thick, it is necessary to react tungsten hexafluoride with hydrogen. Selectivity is lost in such a reaction after about 100 nm (1000 Angstroms) of tungsten growth on the conductor surfaces, as disclosed by Saraswat et al, in Selective CVD of Tungsten for VLSI Technology, Stanford University, May 1984.

The selectivity of metal deposition is known to be dependent on the deposition process conditions including temperature, pressure and reactant concentration in addition to the composition of the substrate surface. These reaction variables can be controlled within conventional chemical vapor deposition reactors. The apparatus and process of this invention provide enhanced selectivity of metal deposition by controlling additional variables, such as the level of infrared radiation which impinges upon the depositing surfaces of the substrate.

According to the present invention there is provided a chemical vapor deposition apparatus for depositing materials on a substrate having a depositing surface containing metal surfaces, semiconductor surfaces or both, said apparatus comprising a cold-wall reaction chamber, a means within said chamber and below the substrate having a hot surface for heating said substrate to a temperature above 100°C, a means for transporting a gaseous reactant to the substrate depositing surface, and a means for isolating the depositing surface of the substrate from infrared radiation generated within said cold-wall reaction chamber and eventually from vaporized nucleating species produced during chemical vapor deposition, charaterized in that said isolating means is selected from:

(a) a solid infrared filter and/or reflector disposed within said cold-wall chamber above the depositing surface and extending up to 3.175mm from the depositing surface in the direction of heat radiated from the hot surface to the substrate;

(b) a solid infrared filter and/or reflector disposed within said cold-wall chamber along the plane of the depositing surface and extending from or from close of the periphery of the depositing surface a longer distance than 3.175mm along the plane of the depositing surface; and

(c) a solid infrared filter and/or reflector in the form of a barrier disposed within said cold-wall chamber in contact with the periphery of the depositing surface and extending at least 3.175mm in the direction of heat radiated from the hot surface to the substrate.

The process of this invention is directed to a method of selectively depositing metal films on a substrate using the chemical vapor deposition apparatus described above.

An object of the present invention is to provide a method and apparatus which will deposit tungsten selectively at a thickness above 100 nm (1000 Angstroms) on a patterned substrate containing metal surfaces and/or semiconductor surfaces.

A further object of the invention is to provide a method and apparatus capable of depositing tungsten selectively at rates in excess of 10 nm (100 Angstroms) per minute.

Another object of the present invention is to provide a method and apparatus for heating substrates, such as silicon wafers, within conventional chemical vapor deposition reactors which permit the selective deposition of metal films, such as tungsten.

A further object of the present invention is to deposit tungsten selectively within a CVD reactor utilizing a resistance heater to heat the substrate.

An additional object of the present invention is to provide a means for isolating the depositing surfaces of a substrate from infrared radiation and vaporized nucleating species which is adaptable to many reactor designs.

Other objects will be apparent from the detailed description which follows.

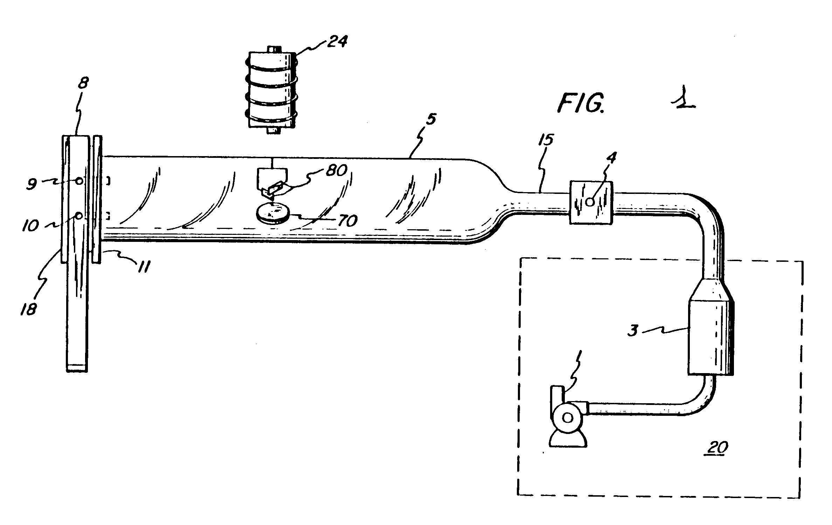

Figure 2 is a schematic representation of a chemical vapor deposition apparatus for use with the present invention which utilizes a radio frequency energy source coupled with a susceptor.

Figure 2 is a schematic representation of a chemical vapor deposition apparatus for use with the present invention which utilizes a resistance heater as an energy source.

Figure 3 is a schematic representation of a heating apparatus used in an embodiment of this invention which comprises a resistance heater and a plate barrier.

Figure 4 is a cross-sectional side view of the apparatus shown in Figure 3.

Figure 5 is a schematic representation of a heating apparatus used in an embodiment of this invention which comprises a resistance heater and a quartz ring barrier.

Figure 6 is a side view of the apparatus shown in Figure 5.

The present invention provides a chemical vapor deposition process and apparatus which enhances the selective deposition of metal films on substrates, such as silicon waters commonly employed in the electronics industry in the manufacture of integrated circuits, transistors, and the like. The term "selective deposition" utilized herein and in the claims refers to deposition on particular materials on a substrate to the exclusion of dissimilar materials of that substrate such as, for example, the deposition on metal and/or semiconductor surfaces to the exclusion of deposition on insulator surfaces of a substrate. The substrate may be glass, a silicon wafer or other suitable material. The most common are electronic devices having patterned metal and semiconductor surfaces thereon such as integrated circuits.

The apparatus of this invention is for use with a wide variety of metal and semiconductor containing gases which deposit films on substrates, including metal carbonyls, metal fluorides, silane and germane. The apparatus is adaptable to all chemical vapor deposition processes. The process of this invention is directed to the deposition of metal films selectively, such as tungsten and molybdenum. While in some cases, it is desirable to produce a selective film having a thickness of a few nanometers (tens of Angstroms), the process and apparatus of this invention can provide films having a thickness above one micrometer.

Several embodiments of the apparatus comprising this invention are disclosed herein. Each of such embodiments employs the same basic concepts characteristic of the improved features of this apparatus, namely the use of a means for isolating the depositing surface of a substrate from undesired radiation. A common element in all embodiments of the apparatus is the use of a cold-wall reaction chamber or reactor, which helps achieve the objectives of this invention. The process of this invention also incorporates operating conditions which are characteristic of cold-wall reactors.

The terms "cold-wall reaction chamber" and "cold wall reactor", as used herein, refer to a system wherein only the substrates and/or the surface on which the substrates are placed are heated to the reaction temperature within the reaction chamber. In a "hot-wall reactor", the entire reaction chamber is heated to the reaction temperature, typically by a resistance heater wrapped around the chamber. In a cold-wall reaction chamber, the chamber walls remain unheated during the reaction. By maintaining the reaction chamber walls in an unheated state, such walls receive little or no film deposition during substrate coating. Therefore, the reactant gases are not depleted. By utilizing a cold-wall reactor, the radiation which impinges upon the substrate is controlled more easily.

A common cold-wall system utilizes radio frequency (RF) induction heating to heat a conducting susceptor positioned within the reaction chamber, the walls of which are formed of a non-conducting or insulating material to RF. The substrate is then heated by radiant energy emitted from the susceptor. For example, an external RF generator will transmit energy to a graphite susceptor within a quartz reaction chamber which, in turn, heats substrates positioned thereon, such as silicon waters. The RF energy used typically has a frequency in the order of 5 kHz to 500 kHz.

In an embodiment of the apparatus, a radiant energy source is used to heat a susceptor positioned within the reaction chamber. The walls of the reaction chamber are transparent to the radiant energy transmitted, which is predominantly short wave length radiation within the visible light or ultraviolet light range.

Another embodiment is one in which a hot surface, such as that of a resistance heater or susceptor is used within the reaction chamber to heat substrates directly. Preferably, only the non-depositing surfaces of the substrates are heated directly by the hot surface. The depositing surfaces of the substrates are protected from radiation emitted by the resistance heater by such means as filters and reflectors positioned within the reactor. Since the source of undesirable radiation is limited in such a configuration, impingement of such radiation upon the depositing surfaces of the substrates can be controlled. It is preferable that this hot surface does not heat the depositing surfaces of the substrate directly in that it is inconsistent with isolating this surface from impinging infrared radiation. It is preferable to have the hot surface in close proximity to the non-depositing surfaces of said substrate. This enhances the efficiency of the heating process and provides greater control over the infrared radiation which strays from said hot surface. It may be desirable for the hot surface to contact the non-depositing surfaces. It should be noted that contact between the hot surface and the non-depositing surface is not essential to practice this invention and embodiments which utilize spacers or other means for separating these two elements are within the scope of this invention.

It is preferable to maximize contact between the non-depositing surface and the hot surface so as to enhance the heating efficiency and uniformity. It should be realized, however, the hot surface can be either larger, smaller or equivalent in area to the non-depositing surface. Where a silicon wafer is utilized, it is preferable to have the hot surface conform to the shape of the silicon wafer. For a circular silicon wafer, a hot surface having a diameter either equal to or slightly smaller than, i.e., up to about 1% smaller, is preferred.

The hot surface preferably forms part of a heat source such as a resistance heater or a susceptor coupled with an external radio frequency generator or light source. The susceptor is a solid which is opaque to RF and/or visible radiation. Where opaque to RF radiation, a radio frequency generator heats the susceptor within the reaction chamber by radio frequency induction heating. The radio frequency energy used may have a frequency in the order of 5 kHz to 500 kHz. The non-depositing surfaces of the substrate are then heated by the susceptor. Where an external light source is utilized with a susceptor opaque to visible light, the susceptor absorbs the visible light radiation and heats the substrate. The susceptors for radio frequency energy and visible light energy are preferably comprised of graphite.

The resistance heaters which are suitable for use in this invention are those which are known to the art. Resistance wires which heat a nickel or nickel alloy, for example, monel or stainless steel heat blocks are suitable. Customized resistance heaters may be preferred so as to improve the uniformity of heating. It will be recognized by those skilled in the art that the size and type of resistance heater and/or susceptor can be varied widely without departing from the scope of this invention.

The apparatus and method of this invention are not limited by the configuration or dimensions of the reaction chamber. They encompass the several different types of reactor configurations which have evolved to meet selective requirements of chemical vapor deposition. Among those presently utilized are the horizontal, vertical, cylindrical, and tubular systems. In the horizontal system, silicon wafers are typically processed lying flat or on a moving belt in a continuous process furnace. The vertical reactor typically employs a vessel, such as a bell jar, in which the wafers are placed on a susceptor disc which rotates continually for uniform coverage. The tubular and cylindrical reactors are similar to the horizontal system with the wafers being peripherally mounted in the cylindrical system and multi-tiered carriers being used in the tubular system.

A conventional chemical vapor deposition apparatus, upon which the apparatus of this invention is based, comprises: (1) means for transporting the reactant gases to the substrate surface which permits absorption of the reactants on the surface and (2) means for heating the surface of the substrate to permit reaction of the absorbed reactants. The chemical deposition procedures within the reaction chamber of this invention are very similar to those employed by known coating procedures, the primary distinction being that undesired radiation does not impinge the depositing surface.

The apparatus of this invention is suitable for depositing metal films and other vapor deposited materials by chemical reaction, typically a reduction reaction, and/or thermopyrolysis of the reacting gas. Alternative chemical vapor deposition processes are low pressure systems where reaction takes place at sub-atmospheric pressure. In addition, plasma-assisted chemical vapor deposition techniques, where lower deposition temperatures are utilized, can be performed in the apparatus of this invention. Alternative uses of the apparatus will be apparent to those skilled in the art from the detailed description herein.

The means for isolating the depositing surface of a substrate from infrared radiation generated within the cold-wall chamber is more commonly a filter or reflector disposed within the cold wall reaction chamber. Filters will absorb infrared radiation while reflectors direct such radiation away from the depositing surface. The filter and/or reflector may be comprised of a material which both absorbs and reflects infrared radiation in varying degrees. Filters are preferred since they are often simple to utilize.

Since reflectors or filters are positioned within the reaction chamber solid reflectors or filters are conveniently utilized. The preferred solid materials for infrared filters are inert within the chemical vapor deposition reactor, such as quartz and nickel. Quartz filters/reflectors are most preferred in that the reaction chamber is often comprised of quartz and therefore the material is not foreign to the chemical vapor deposition reaction.

The filter/reflector material may extend either above, below or along the plane of the depositing surface.

Filter/reflector materials which extend in the same direction as the heat transferred from the hot surface to the substrate need only extend a short distance to be effective. For example, where the hot surface is below the substrate, filters/reflectors which extend up to 3.175mm (⅛") from the depositing surface, i.e., in the direction of heat radiated to the substrate, are suitable. Filter/reflector materials which do not extend in the direction of heat radiation to the substrate must extend a longer distance than 3.175 mm (⅛"). For example, when the hot surface is below the substrate, filters/reflectors positioned along the plane of the depositing surface preferably extend across the width of the reaction chamber to ensure absorption or reflection of all infrared radiation which will impinge the depositing surface.

Where the hot surface extends beyond the edge of the substrate, it is preferable for the filter/reflector material to contact the periphery of the depositing surface. This ensures the infrared radiation emitted by the hot surface will not pass between the filter/reflector material and the substrate. Where the hot surface does not extend beyond the edge of the substrate, the filter/reflector material need not contact the depositing surface. A space between the filter/reflector material and the depositing surface of about 1 millimeter is often preferred.

The vaporized nucleating species are preferably isolated from the depositing surface by the same element or apparatus which filters and/or reflects infrared radiation. Such an apparatus is referred to herein as a "barrier". The barrier must be an inert solid which has a temperature below the temperature of the depositing surface.

The barrier must be cooler than the depositing surface so as to condense the vaporized nucleating species thereon. This serves to intercept those nucleating species and prevent contact with the depositing surface. Preferably, the barrier has a temperature of about 100°C below that of the depositing surface and most preferably, this temperature has a value below 200°C.

The number of inert materials which will function as a barrier is extensive. Materials which are suitable for use as solid infrared filters and/or reflectors are also suitable barrier materials. Most solid metals are inert in the CVD reactor and are suitable, including nickel; however, quartz is preferred since it is already present within the reactor walls.

In that a barrier also functions as an infrared filter and/or reflector, its configuration will principally be dictated by the need to isolate impinging infrared radiation. The edges of the barriers must be in close proximity to the depositing surface, preferably within 1 millimeter. These barriers are also in close proximity to the depositing surface. Those infrared filters and/or reflectors which surround the periphery of the depositing surface are well suited for intercepting vaporized nucleating species and are excellent barriers.

As with infrared filters and/or reflectors, the barrier can extend above, below or along the plane of the depositing surface.

The existence of the vaporized nucleating species is demonstrated by deposition on the barriers and absorbers utilized. It is believed hot surfaces within the reaction chamber vaporize materials which have formed on them during the CVD reaction. Some, or all, of these vaporized species provide sites for the CVD reaction.

Referring to the apparatus shown in Figure 1, it should be understood that the chemical vapor deposition apparatus is shown in generally schematic fashion. The elements illustrated are typically within a surrounded enclosure in which the necessary gaseous reactant flow controls, electrical power sources, and other attendant mechanisms are housed and mounted. Such an enclosure is for safety purposes only and is not necessary for the remaining elements to provide the desired objects. The portions of the apparatus illustrated can be supported within such an enclosure in any suitable fashion.

The reaction chamber of the chemical deposition apparatus wherein deposition takes place is generally designated 5. The reaction chamber illustrated comprises an elongated enclosed tubular structure formed from a material which is transparent to the radiant energy generated by source 24, described more particularly below. The reaction chamber preferably has its walls formed of quartz, which is transparent to radiant energy in the wavelength range of one crometer or below and RF frequencies. A suitable dimension for the tubular structure is one having a width of 15.24 cm (6 inches) with a length of about 50.8 cm (20 inches), but the dimensions thereto may vary according to the production needs. In addition to the dimensions, the shape of the reactor may also vary within a wide range. The tubular structure illustrated is generally circular in cross-sectional area. As shown in Figure 1, one end of the reaction chamber forms exhaust port 15 which is, in turn, connected to an exhaust system 20 so that spent reaction gases may be withdrawn from the reactor. Exhaust system 20 comprises a vacuum pump 1 and absorption trap 3 to collect by-products. At its opposite end, gaseous reactants to be employed in a coating procedure are introduced into the reaction chamber through means, which in the embodiment illustrated, comprise a pair of conduits 9 and 10 which pass through a manifold 8 which seals off the reactor with backplate 11. These conduits terminate within the reaction chamber permitting gaseous reactants to emanate therefrom. It should be understood that a particular means chosen for introducing the gaseous reactants into the reaction chamber may be varied to meet particular manufacturing and production requirements. A slideable door 18 permits access to the interior of the reaction chamber. Access to the hollow interior through the end of the reaction chamber is necessary so that substrates to be coated can be loaded and unloaded therefrom prior to and following deposition thereon. To control the flow of gaseous reactants over the substrates (and prevent impurities from entering the reactor during shut down), a nitrogen backfill inlet 4 may be used in exhaust port 15 to supply nitrogen to the system.

The radiant energy source 24, i.e. the RF source, generates and transmits a wave length in the range of about 0.1 to 100 meters. Any number of configurations are suitable for the RF source 24 provided the radiation transmitted will impinge a susceptor 70 positioned within the reaction chamber. In the embodiment described within Figure 1, the RF generator is shown perpendicular to the silicon wafer and susceptor. Since the silicon wafer is typically transparent to RF radiation, the susceptor is a necessary element in this embodiment. The susceptor is positioned beneath the silicon wafer so as to contact only the non-depositing surface of the silicon wafer. For such a configuration, infrared radiation generated by the susceptor impinges only the non-depositing surface of the silicon wafer. The susceptor is preferably comprised of graphite, which readily absorbs and conducts radiant heat energy from the RF frequencies at short wave lengths.

Reflectors 80 are positioned within the reactor so as to deflect foreign infrared radiation generated within the reaction chamber. These reflectors are preferably comprised of gold. Since gold is not transparent to RF radiation, it is preferable to position the reflectors well above the depositing surface of the silicon wafer. However, the configuration of the reflectors can vary widely.

Figure 2 illustrates an alternative apparatus for use with the present invention wherein the silicon wafer is heated within the reaction chamber by a resistance heater. Reaction chamber 5 is as described in Figure 1. The particular features of this reaction chamber are not repeated here for the sake of brevity. Common reference numerals of Figures 1 and 2 label similar elements. Resistance heat source 100 is positioned within the reaction chamber and is similar to the susceptor utilized in Figure 1. It is powered by leads 110 and 111. The resistance heater contacts only the non-depositing surfaces of the silicon wafer. This avoids direct impingement of the infrared radiation generated by the resistant heater onto the depositing surface of said silicon wafer. Reflectors 105 are positioned within the reaction chamber so as to prevent stray infrared radiation from impinging on the depositing surface of the silicon wafer. These reflectors function in a similar manner to those described in Figure 1.

The resistance heater 100 can be of any type which is inert to the reactant gases that are passed through said reaction chamber. The resistance heater typically must provide a temperature in the range of about 100°C to 700°C. It is preferable to utilize a resistance heater which has a configuration that conforms to the profile of the silicon wafers or other substrates utilized.

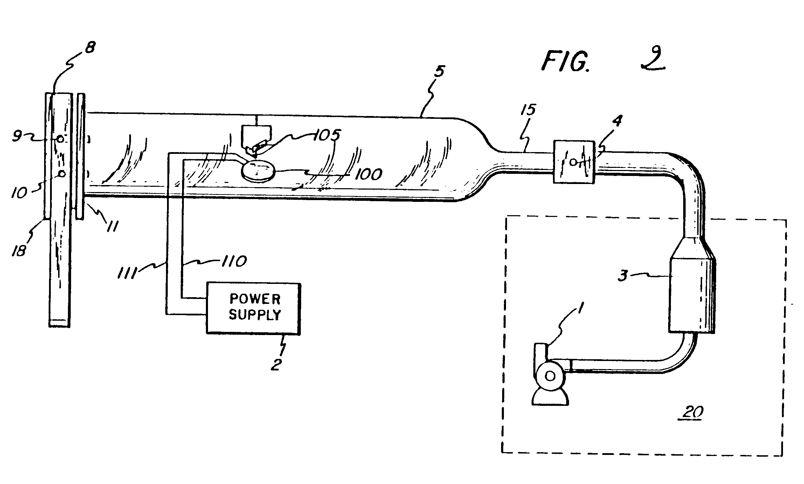

Referring to the heating apparatus shown in Figures 5 end 6, it should be understood that the apparatus shown will be supported within a cold wall chemical vapor deposition reaction chamber. Such support can be provided by any conventional means.

The hot surface is provided by resistance heater 210, with leads 25 connected thereto and extending out of the reaction chamber to a current source. Silicon wafer 225 is supported thereon and is smaller in diameter than the resistance heater 210. The silicon wafer does not form part of this invention but is illustrated to show how the apparatus performs. The means for isolating the depositing surface of the silicon wafer from infrared radiation and the vaporized nucleating species produced by the resistance heater 210 is ring 230. Ring 230 rests on the resistance heater 210, centered about the silicon wafer. The ring contacts the outer periphery of the silicon wafer in the embodiment shown. The resistance heater is in direct contact with the non-depositing surface of the silicon wafer and transfers heat directly thereto.

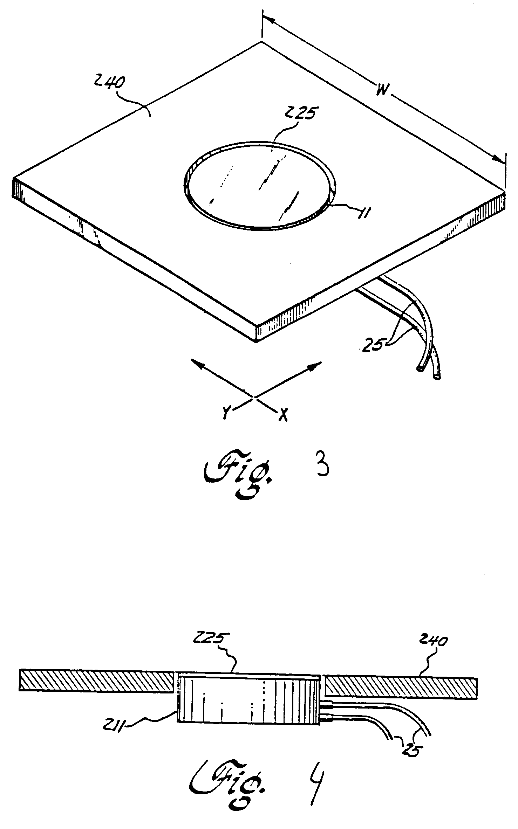

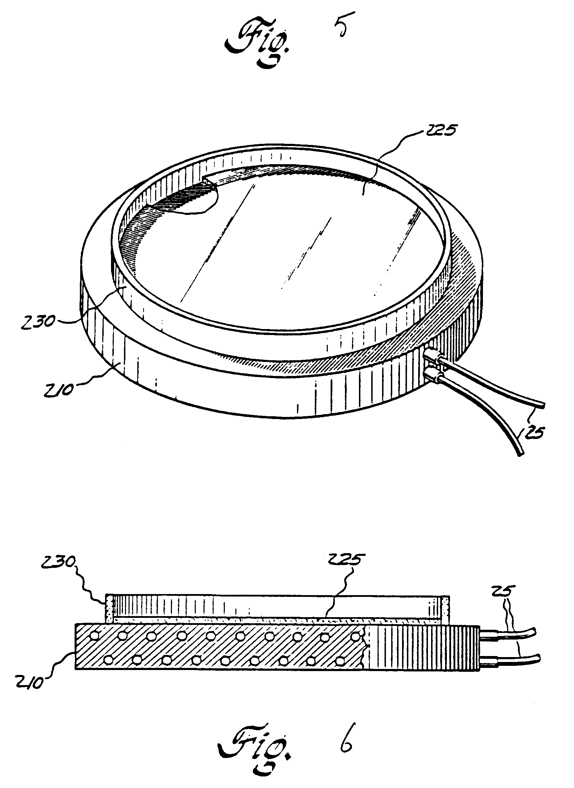

The embodiment illustrated in Figures 3 and 4 is a heating apparatus which utilizes a barrier that extends across the plane of the depositing surface. Resistance heater 211 is similar to that described in Figures 5 and 6 It supports silicon wafer 225 and is of an equal diameter to said wafer. Leads 25 provide current to the resistance heater from outside the reaction chamber. The barrier is a plate 240 having an aperture of an inner diameter 2 millimeters longer than the diameter of the silicon wafer. This aperture is positioned over the resistance heater in the plane of the depositing surface (X, Y). The width of the plate, W, is equivalent to the width of the cold wall reaction chamber.

It should be realized that the shape of the plate and ring illustrated can vary widely with the reactor utilized. It should further be realized that a susceptor may be used in place of the resistance heater for these embodiments.

The apparatus of this invention may be operated in either a "static mode", in which the chamber is closed off during deposition, or a "dynamic mode", in which a continuous flow of reactant deposition gas is passed through the chamber. The gas is preferably deposited in a dynamic mode to achieve thick films of the depositing material.

The process of this invention is directed to the selective deposition of metals on semiconductor and metal surfaces. It is based on conventional processes for the vapor deposition of metals coupled with the distinguishing feature of isolating the depositing surface of the substrate from infrared radiation during reaction of the gaseous reactant.

The metal to be deposited is preferably tungsten or molybdenum. To obtain thick films of these metals, the gaseous reactant is reduced with a reducing atmosphere such as hydrogen. Suitable depositing gases for molybdenum and tungsten include $WF_6$, $W(CO)_6$, $MoF_6$, $MoCl_5$, $Mo(CO)_6$ and the like. The reduction reaction takes place at a temperature above about 200°C. The preferred temperature falls within the range of about 250° to 650°C and the total pressure within the reactant is preferably within the range of 13.6 to 266.6 Pa (0.1 to 2 Torr). The preferred gaseous reactants are the combination of tungsten hexafluoride and hydrogen. Preferred mixtures of these constituents provide a hydrogen to tungsten hexafluoride ratio in the range of 1:1 to 3000:1. The throughput rate for such reaction mixtures preferably falls within the range of 0.1 to 5 liters per minute.

In that certain filters/reflectors need only extend 3.175 mm (⅛") from the depositing surface, it is inferred that impinging infrared radiation having a low angle of incidence from the plane of said depositing surface, i.e., from about 0° to 45°C, is most critical. However, it is preferable to isolate all of such infrared radiation.

The substrates on which deposition takes place contain metal and semiconductor surfaces. They are most often silicon wafers with an integrated circuit pattern of insulators, metals and semiconductors. The insulator surfaces are typically $SiO_2$ and/or $Si_3N_4$ and the semiconductor surfaces are silicon. The metals can include platinum, molybdenum, titanium, tungsten, tantalum, aluminum and the like. Also included are the silicides of such metals described more particularly below.

To perform this process efficiently, the silicon wafers are first loaded into a chemical vapor deposition apparatus. The reaction chamber of such an apparatus is typically at a reduced pressure, i.e. below one atmosphere. Next, the silicon wafer is heated to the desired deposition temperature with radiant energy. The gaseous reactant/hydrogen mixture is then passed over the silicon wafer and metal deposition commences on the surfaces. The wafer is isolated from a substantial portion of impinging infrared radiation while the wafer is contacted with the depositing gas.

It will be understood that while the following examples primarily involve selective deposition of tungsten, the apparatus of the present invention is applicable to deposition of a wide variety of metallic compounds from a large number of deposition gases. The gases considered most useful for deposition in the context of the apparatus of the present invention are, without limitation: $Mo(CO)_6$, $W(CO)_6$, $Cr(CO)_6$, $Co(NO)_3(CO)_3$, $WF_6$, $MoF_6$, $MoCl_5$, etc. In addition, although the examples are primarily directed to deposition on silicon surfaces, the apparatus of the present invention is applicable to deposition on a wide variety of conductor and semiconductor surfaces. Suitable conductor surfaces are those provided by metals and alloys thereof including, for example, platinum, molybdenum, titanium, tungsten, tantalum, aluminum, and the like, including mixtures thereof. Other suitable conductors include transition metal silicides, such as tungsten silicide, molybdenum silicide, titanium silicide, titanium silicide, platinum silicide, and the like.

The following examples are provided to illustrate the particular embodiments of this invention. These examples are not provided with the intention of limiting the scope of this invention to the embodiments disclosed.

EXAMPLE 1

Into a cylindrical, quartz reaction chamber having a width of 152.4 mm (6") a length of about 50.8 cm (20") was placed a heating apparatus as shown in Figures 5 and 6. A monel plate having a diameter of 76.2 mm (3") functioned as the resistance heater. Two insulated nickel leads provided current to the heating wire through the access door of the reaction chamber. The monel blocks supported a circular silicon wafer having a diameter of 76.2 mm (3"). The barrier utilized was a quartz ring having a 76.2 mm (3") outer diameter, a 3.175 mm (⅛") thickness and 6.35 mm (¼") height. The barrier defined the periphery of the depositing surface. A slideable door in the reactor provided access to the interior of the reaction chamber. The gaseous reactants, tungsten hexafluoride and hydrogen were introduced into the reaction chamber through a pair of conduits that passed through a manifold which sealed off the reactor. The reactor was exhausted at the opposite end of the reaction chamber with the use of a vacuum pump and an absorption trap. A nitrogen backfill was also utilized to prevent impurities from entering the reactor during shutdown.

The substrate utilized was a silicon wafer covered by an insulator surface of silicon dioxide (400 nm (4000 Angstroms) which was etched for 30 seconds in 1% hydrofluoric acid. The pressure within the reactor was approximately 80 Pa (0.6 Torr) and a flow of 300 sccm of hydrogen was maintained during reaction. The heat block was heated from room temperature to 360°C over a 105 minute period, at which time tungsten hexafluoride was introduced to the system at 10 sccm. After 10 minutes of the tungsten hexafluoride and hydrogen atmosphere, the wafer was cooled and removed from the reactor.

Tungsten was deposited on the outside edge of the wafer but no tungsten deposited on the oxide of the wafer inside the ring. As a comparative example, a similar wafer with the same conditions was heated to room temperature to 360°C over a 105 minute period without the use of the quartz ring. After heating, tungsten hexafluoride was introduced to the system at 10 sccm per minute. After 5 minutes, the wafer was coated with a non-selective layer of tungsten over the entire oxide surface.

EXAMPLE 2

The same cold wall reactor and heating apparatus as used in Example 1 was utilized in this example. A 76.2 mm (3") silicon wafer having a molybdenum layer with 1600 nm (16,000 Angstroms) of silicon dioxide deposited thereon was utilized. Vias were etched in the silicon dioxide down to the molybdenum surface. This wafer was placed on a secondary wafer having a 400 nm (4000 Angstroms) low pressure chemical vapor deposition oxide (LPCVD) deposited thereon. This secondary wafer isolated the bare silicon back of the top wafer from the heated block. The same quartz ring as utilized in Example 1 was centered on top of the wafer. The running conditions were identical to that of Example 1 and the wafer was exposed to tungsten hexafluoride and hydrogen for 8 minutes. Deposition was selective with 800 nm (8000 Angstroms) of tungsten being deposited in the vias.

EXAMPLE 3

A similar apparatus to that utilized in Example 1 was utilized in this example. A similar wafer as that utilized in Example 2 was placed on a secondary silicon wafer which served to isolate the water from the heated block. The same quartz ring as that utilized in Examples 1 and 2 was utilized in this example. Process conditions were identical to that of Example 2 except the exposure to tungsten hexafluoride and hydrogen was extended to 15 minutes. This resulted in a selective deposition of tungsten and a thickness of about 1500 nm (15,000 Angstroms) within the 1600 nm (16,000 Angstroms) deep vias.

As a comparative example, a similar wafer was exposed to tungsten hexafluoride and hydrogen within the same apparatus under the same process conditions for a period of 15 minutes. Deposition of tungsten was found to be non-selective and continuous for about 12.7 mm ($\frac{1}{2}$") around the perimeter of the wafer.

EXAMPLE 4

The cold wall reactor of Example 1 was utilized in this example. The heating apparatus of this example was that as shown in Figures 5 and 6. The heated block having a diameter of 76.2 mm (3") and a quartz ring barrier were also the same as that utilized in Example 1.

The wafer to be treated was a 76.2 mm (3") silicon wafer having a molybdenum layer over which was deposited silicon dioxide by plasma enhanced chemical vapor deposition (PECVD). The PECVD silicon dioxide had a thickness of approximately 2200 nm (22,000 Angstroms). Vias were etched into this silicon dioxide layer of about 2200 nm (22,000 Angstroms), which exposed the molybdenum layer.

The pressure within the reactor was approximately 80Pa (0.6 Torr) with a flowing atmosphere of hydrogen at a rate of 300 sccm during the reaction. The ring was centered around the outer periphery of the primary silicon wafer with the etched vias. The block was heated from room temperature to 425°C at the time the tungsten hexafluoride was introduced. The wafer was exposed to hydrogen and tungsten hexafluoride for 15 minutes, resulting in the selective deposition of 2150 nm (21,500 Angstroms) of tungsten within the 2200 nm (22,000 Angstroms) deep vias.

EXAMPLE 5

A similar cold wall reaction chamber as that described in Example 1 was utilized in this example. The heating apparatus of this example was that illustrated in Figures 3 and 4. A heated block having a diameter of 76.2 mm (3") was utilized to provide the hot surface. Insulated conducting leads provided the necessary current to the heating wire attached to the monel block via the manifold of the reactor. The barrier utilized in this example extended across the plane of the depositing surface and comprised a nickel plate having a 152.4 mm (6") width, 152.4 mm (6") length and a 0.508 mm (0.02") thickness. The nickel plate had an aperture of 76.2 mm (3") which was centrally disposed over the heated monel block. The nickel plate extended to within 1 millimeter of the edge of said silicon wafer.

The substrate utilized was a 76.2 mm (3") silicon wafer having 400 nm (4000 Angstroms) of low pressure chemical vapor deposition silicon dioxide deposited thereon. The wafer was circular in configuration and had a diameter equal to the diameter of the heated block. The wafer was placed on the heating block and the reaction chamber evacuated to 80 Pa (0.6 Torr) with a flowing atmosphere of hydrogen of about 300 sccm. The block was heated from room temperature to about 400°C over a 100 minute period, at which time tungsten hexafluoride was introduced to the system at a rate of 10 sccm. After 10 minutes of the tungsten hexafluoride/hydrogen atmosphere, the wafer was removed and tungsten deposition was found to be selective. No tungsten deposited on the oxide of the wafer.

EXAMPLE 6

The same chemical vapor deposition reactor of Example 1 was utilized in this example and the reaction conditions and heating apparatus were as described in Example 5. A 76.2 mm (3") silicon wafer having a molybdenum layer over which was deposited a 900 nm (9000 Angstroms) thick layer of PECVD silicon dioxide was utilized. The silicon dioxide was etched to expose the underlying molybdenum layer. Upon treating the silicon wafer to the conditions as described in Example 5 for about 15 minutes, a 1500 nm (15,000 Angstroms) deposition of tungsten was noted within the vias with no deposition on the silicon dioxide surface.

**Claims**

1. A chemical vapor deposition apparatus for depositing materials on a substrate having a depositing surface containing metal surfaces, semiconductor surfaces or both, said apparatus comprising a cold-wall reaction chamber, a means within said chamber and below the substrate having a hot surface for heating said substrate to a temperature above 100°C, a means for transporting a gaseous reactant to the substrate depositing surface, and a means for isolating the depositing surface of the substrate from infrared radiation generated within said cold-wall reaction chamber and eventually from vaporized nucleating species produced during chemical vapor deposition, charaterized in that said isolating means is selected from:
    (a) a solid infrared filter and/or reflector disposed within said cold-wall chamber above the depositing surface and extending up to 3.175mm from the depositing surface in the direction of heat radiated from said hot surface to the substrate;
    (b) a solid infrared filter and/or reflector disposed within said cold-wall chamber along the plane of the depositing surface and extending from or from close of the periphery of the depositing surface a longer distance than 3.175mm along the plane of the depositing surface; and
    (c) a solid infrared filter and/or reflector in the form of a barrier disposed within said cold-wall chamber in contact with the periphery of the depositing surface and extending at least 3.175mm in the direction of heat radiated from the hot surface to the substrate.

2. An apparatus as in claim 1 wherein the means for heating the substrate above 100°C comprises a susceptor within the reaction chamber which transmits radiant energy to the non depositing surface of the substrate and a means for heating the susceptor.

3. An apparatus as in claim 2 wherein the susceptor is opaque to radio frequencies and the means for heating the susceptor is a radio frequency generator.

4. An apparatus as in claim 1 wherein the means for heating the substrate above 100°C is a resistance heater positioned within the reaction chamber.

5. An apparatus as in claim 1 wherein the hot surface of said heating means within the cold wall reaction chamber heats said substrate above 200°C by heat transfer to the non-depositing surfaces of said substrate.

6. An apparatus as in claim 5 wherein the means for isolating the depositing surface of said substrate from impinging infrared radiation generated within said cold-wall chamber and nucleating species vaporized by the hot surface is a barrier as defined in claim 1 (c) and is comprised of an inert solid material which is cooler than the depositing surface.

7. An apparatus as in claim 6 wherein said barrier extends along the same plane as the depositing surface.

8. An apparatus as in claim 7 wherein said barrier is a plate which approaches the periphery of the depositing surface to within 1 millimeter and extends the entire width of the reaction chamber.

9. An apparatus as in claim 6 wherein the barrier contacts the periphery of the depositing surface.

10. An apparatus as in claim 9 wherein the barrier extends above the plane of the depositing surface.

11. An apparatus as in claim 10 wherein the depositing surface is circular and said barrier is a ring.

12. An apparatus as in claim 8 or 11 wherein said plate is comprised of quartz or nickel.

13. A method for effecting selective chemical vapor depositions on metal and semiconductor surfaces of a substrate comprising:

(A) placing a substrate having a depositing surface comprised of metal surfaces, semiconductor surfaces or both within a chemical vapor deposition apparatus as set forth in anyone of claims 1 to 12;

(B) heating the substrate above 200°C with the heating means within the reaction chamber without appreciable absorption of radiant energy by the reaction chamber walls; and

(C) contacting the heated substrate with a gazeous reactant to form a metal film on the depositing surface, said metal being selected from the group consisting of tungsten and molybdenum.

14. A method as in claim 13 wherein the substrate is heated to a temperature within the range of 250°C to 650°C and the total pressure is in the range of (0.1 to 2 Torr) 13.3 to 266.6 Pa.

15. A method as in claim 14 wherein the substrate is a silicon wafer with an integrated circuit pattern having surfaces provides by materials selected from the group consisting of insulators, metals and semiconductors.

16. A method as in claim 15 wherein the insulator surfaces are selected from the group consisting of $SiO_2$ and $Si_3N_4$ and the metals are selected from the group consisting of platinum, molybdenum, titanium, tungsten, tantalum, aluminium and silicides thereof, and the semiconductor surface is silicon.

17. A method as in claim 16 wherein the gaseous reactants are tungsten hexafluoride and hydrogen.

18. A method as in claim 17 wherein the ratio of hydrogen to tungsten hexafluoride falls within the range of 3 to 50.

19. A method as in claim 18 wherein the throughout rate for the gaseous reactants is within the range of 0.1 to 2 liters per minute.

**Revendications**

1. Appareil de dépôt en phase vapeur par procédé chimique pour le dépôt de matériaux sur un substrat ayant une surface de dépôt contenant des surfaces de métaux, des surfaces de semi-conducteurs ou les deux, cet appareil comprenant une chambre de réaction à paroi froide, un moyen à l'intérieur de la chambre et au-dessous du substrat présentant une surface chaude pour chauffer le substrat à une température supérieure à 100°C, un moyen pour transporter un réactif gazeux vers la surface de dépôt du substrat et un moyen pour isoler la surface de dépôt du substrat du rayonnement infrarouge produit à l'intérieur de la chambre de réaction à paroi froide et, éventuellement, des espèces vaporisées, provoquant une germination, produites pendant le dépôt en phase vapeur par procédé chimique, caractérisé en ce que le moyen pour isoler est choisi parmi :

(a) un filtre et/ou réflecteur des infrarouges solide placé à l'intérieur de la chambre à paroi froide au-dessus de la surface de dépôt et s'étendant jusqu'à 3,175 mm de la surface de dépôt dans la direction de la chaleur rayonnée de la surface chaude vers le substrat ;

(b) un filtre et/ou réflecteur des infrarouges solide placé à l'intérieur de la chambre à paroi froide dans le plan de la surface de dépôt et s'étendant à partir de la périphérie de la surface de dépôt ou du voisinage de celle-ci sur une distance supérieure à 3,175 mm dans le plan de la surface de dépôt; et

(c) un filtre et/ou réflecteur des infrarouges solide sous forme d'une barrière placée à l'intérieur de la chambre à paroi froide en contact avec la périphérie de la surface de dépôt et s'étendant sur au moins 3,175 mm dans la direction de la chaleur rayonnée de la surface chaude vers le substrat.

2. Appareil selon la revendication 1, dans lequel le moyen pour chauffer le substrat au-dessus de 100°C comprend une susceptance à l'intérieur de la chambre de réaction qui transmet de l'énergie rayonnante à la surface du substrat qui n'est pas la surface de dépôt et un moyen pour chauffer la susceptance.

3. Appareil selon la revendication 2, dans lequel la susceptance est opaque aux hautes fréquences et le moyen pour chauffer la susceptance est un générateur haute fréquence.

4. Appareil selon la revendication 1, dans lequel le moyen pour chauffer le substrat au-dessus de 100°C est un dispositif de chauffage par résistance placé à l'intérieur de la chambre de réaction.

5. Appareil selon la revendication 1, dans lequel la surface chaude du dispositif de chauffage à l'intérieur de la chambre de réaction à paroi froide chauffe le substrat au-dessus de 200°C par transfert de chaleur aux surfaces du substrat qui ne sont pas les surfaces de dépôt.

6. Appareil selon la revendication 5, dans lequel le moyen pour isoler la surface de dépôt du substrat du rayonnement infrarouge incident produit à l'intérieur de la chambre à paroi froide et des espèces provoquant une germination vaporisées par la surface chaude est une barrière telle qu'on l'a définie dans la revendication 1 (c) et se compose d'un matériau solide inerte qui, lors de l'emploi, est plus froid que la surface de dépôt.

7. Procédé selon la revendication 6, dans lequel la barrière s'étend dans le même plan que la surface de dépôt.

8. Appareil selon la revendication 7, dans lequel la barrière est une plaque qui s'approche à 1 mm ou moins de la périphérie de la surface de dépôt et qui s'étend sur toute la largeur de la chambre de réaction.

9. Appareil selon la revendication 6, dans lequel la barrière est en contact avec la périphérie de la surface de dépôt.

10. Appareil selon la revendication 9, dans lequel la barrière s'étend au-dessus du plan de la surface de dépôt.

11. Appareil selon la revendication 10, dans lequel la surface de dépôt est circulaire et la barrière est un anneau.

12. Appareil selon la revendication 8 ou 11, dans lequel la plaque se compose de quartz ou de nickel.

13. Procédé pour effectuer des dépôts sélectifs en phase vapeur par procédé chimique sur des surfaces de métaux et de semi-conducteurs d'un substrat comprenant :
    (A) la mise en place d'un substrat présentant une surface de dépôt composée de surfaces de métaux, de surfaces de semi-conducteurs ou les deux à l'intérieur d'un appareil de dépôt en phase vapeur par procédé chimique selon l'une quelconque des revendications 1 à 12 ;
    (B) le chauffage du substrat au-dessus de 200°C avec le dispositif de chauffage à l'intérieur de la chambre de réaction sans absorption appréciable d'énergie rayonnante par les parois de la chambre de réaction et
    (C) la mise en contact du substrat chauffé avec un réactif gazeux pour former un film métallique sur la surface de dépôt, ce métal étant choisi dans le groupe constitué par le tungstène et le molybdène.

14. Procédé selon la revendication 13, dans lequel on chauffe le substrat à une température comprise entre 250°C et 650°C et où la pression totale est comprise entre (0,1 et 2 torr) 13,3 et 266,6 Pa.

15. Procédé selon la revendication 14, dans lequel le substrat est une pastille de silicium avec un motif de circuit intégré ayant des surfaces constituées par des matériaux choisis dans le groupe constitué par des isolants, des métaux et des semi-conducteurs.

16. Procédé selon la revendication 15, dans lequel les surfaces d'isolants sont choisies dans le groupe constitué par $SiO_2$ et $Si_3N_4$ et les métaux sont choisis dans le groupe constitué par le platine, le molybdène, le titane, le tungstène, le tantale, l'aluminium et leurs siliciures et la surface de semi-conducteur est constituée par du silicium.

17. Procédé selon la revendication 16, dans lequel les réactifs gazeux sont l'hexafluorure de tungstène et l'hydrogène.

18. Procédé selon la revendication 17, dans lequel le rapport de l'hydrogène à l'hexafluorure de tungstène est compris entre 3 et 50.

19. Procédé selon la revendication 18, dans lequel le débit total pour les réactifs gazeux est compris entre 0,1 et 2 litres par minute.

**Patentansprüche**

1. Vorrichtung zum selektiven chemischen Aufdampfen für Abscheidungsmaterialien auf einem Substrat mit einer Abscheidungsfläche, die Metallflächen, Halbleiterflächen oder beides enthält, wobei die Vorrichtung eine Kaltwand-Reaktionskammer, eine Einrichtung innerhalb der Kammer und unterhalb des Substrats mit einer heißen Oberfläche zum Erhitzen des Substrats auf eine Temperatur oberhalb 100°C, eine Einrichtung zum Transportieren eines gasförmigen Reaktionsbestandteils zu der Abscheidungsfläche des Substrats und eine Einrichtung aufweist zum Isolieren der Abscheidungsfläche des Substrats von in der Kaltwand-Reaktionskammer erzeugter Infarotstrahlung und sich daraus ergebender verdampfter kernbildender Spezies, die während dem chemischen Aufdampfen erzeugt wird, dadurch gekennzeichnet, daß die Isolationseinrichtung ausgewählt ist aus:

(a) ein Festkörper-Infarotfilter und/oder Reflektor, das bzw. der innerhalb der Kaltwandkammer oberhalb der Abscheidungsfläche angeordnet ist und sich bis zu 3,175 mm von der Abscheidungsfläche in Richtung von der heißen Oberfläche abgestrahlter Wärme nach dem Substrat erstreckt,

(b) ein Festkörper-Infarotfilter und/oder Reflektor, das bzw. der in der Kaltwandkammer entlang der Ebene der Abscheidungsfläche angeordnet ist und sich von oder nahe von dem Umfang der Abscheidungsfläche sich auf einer größeren Strecke als 3,175 mm entlang der Ebene der Abscheidungsfläche erstreckt, und

(c) ein Festkörper-Infarotfilter und/oder Reflektor in der Form einer Trennwand, die in der Kaltwandkammer in Kontakt mit dem Umfang der Abscheidungsfläche angeordnet ist und sich wenigstens etwa 3,175 mm in Richtung von der heißen Oberfläche abgestrahlter Wärme nach dem Substrat erstreckt.

2. Vorrichtung nach Anspruch 1, wobei die Einrichtung zum Erhitzen des Substrats auf mehr als 100°C einen Aufnehmer (Suszeptor) innerhalb der Reaktionskammer, der Strahlungsenergie an die nicht abscheidende Oberfläche des Substrats sendet, und eine Einrichtung zum Erhitzen des Aufnehmers aufweist.

3. Vorrichtung nach Anspruch 2, wobei der Aufnehmer für Hochfrequenzen undurchlässig ist und die Einrichtung zum Erhitzen des Aufnehmers einen Hochfrequenzgenerator aufweist.

4. Vorrichtung nach Anspruch 1, wobei die Einrichtung zum Erhitzen des Substrats auf mehr als 100°C eine Widerstands-Heizeinrichtung ist, die in der Reaktionskammer angeordnet ist.

5. Vorrichtung nach Anspruch 1, wobei die heiße Oberfläche der Heizeinrichtung innerhalb der Kaltwand-Reaktionskammer das Substrat auf mehr als 200°C erhitzt durch Wärmeübertragung auf die nicht-abscheidenden Oberflächen des Substrats.

6. Vorrichtung nach Anspruch 5, wobei die Einrichtung zum Isolieren der Abscheidungsoberfläche des Substrates von auftreffender Infarotsstrahlung, die innerhalb der Kaltwandkammer erzeugt ist, und kernbildender Spezies, die von der heißen Oberfläche verdampft ist, eine Trennwand nach Anspruch 1 (c) ist und von einem innerten Festkörpermaterial gebildet ist, das bei Verwendung kälter als die abscheidende Oberfläche ist.

7. Vorrichtung nach Anspruch 6, wobei sich die Trennwand entlang der gleichen Ebene wie die abscheidende Oberfläche erstreckt.

8. Vorrichtung nach Anspruch 7, wobei die Trennwand eine Platte ist, die sich dem Umfang der abscheidenden Oberfläche auf innerhalb einen Millimeter nähert und sich über die gesamte Breite der Reaktionskammer erstreckt.

9. Vorrichtung nach Anspruch 6, wobei die Trennwand den Umfang der abscheidenden Oberfläche kontaktiert.

10. Vorrichtung nach Anspruch 9, wobei die Trennwand oberhalb der Ebene der abscheidenden Oberfläche verläuft.

11. Vorrichtung nach Anspruch 10, wobei die abscheidende Oberfläche kreisförmig ist und die Trennwand ein Ring ist.

12. Vorrichtung nach Anspruch 8 oder 11, wobei die Platte aus Quarz oder Nickel gebildet ist.

13. Verfahren zum Herbeiführen selektiver chemischer Dampfabscheidungen auf Metall- und Halbleiterflächen von einem Substrat, enthaltend:

(A) Anordnen eines Substrats mit einer abscheidenden Oberfläche, die aus Metallflächen, Halbleiterflächen oder beiden gebildet ist, in einer Vorrichtung zum selektiven chemischen Aufdampfen nach einem der Ansprüche 1 bis 12,

(B) Erhitzen des Substrats auf mehr als 200°C mit der Heizeinrichtung innerhalb der Reaktionskammer ohne merkliche Absorption von Strahlungsenergie durch die Reaktionskammerwände und

(C) das erhitze Substrat wird mit einem gasförmigen Reaktionsbestandteil in Kontakt gebracht, um einen Metallfilm auf der abscheidenden Oberfläche zu bilden, wobei das Metall aus der aus Wolfram und Molybdän bestehenden Gruppe ausgewählt ist.

14. Verfahren nach Anspruch 13, wobei das Substrat auf eine Temperatur in dem Bereich von 250°C bis 650°C erhitzt wird und der Gesamtdruck in dem Bereich von 13,3 bis 266,6 Pa (0,1 bis 2 Torr) liegt.

15. Verfahren nach Anspruch 14, wobei das Substrat ein Siliziumplättchen mit einem integriertem Schaltungsmuster mit Oberflächen ist, die durch Materialien gebildet sind, die aus der aus Isolationsmitteln, Metallen und Halbleitern bestehenden Gruppe ausgewählt sind.

16. Verfahren nach Anspruch 15, wobei die Isolationsmitteloberflächen aus der aus $SiO_2$ und $Si_3N_4$ bestehenden Gruppe ausgebildet sind und die Metalle aus der aus Platin, Molybdän, Titan, Wolfram, Tantal, Aluminium und deren Siliziden bestehenden Gruppe ausgwählt sind und die Halbleiterfläche Silizium ist.

17. Verfahren nach Anspruch 16, wobei die gasförmigen Reaktionsbestandteile Wolfram-Hexafluorid und Wasserstoff sind.

18. Verfahren nach Anspruch 17, wobei das Verhältnis von Wasserstoff zu Wolfram-Hexafluorid in den Bereich von 3 bis 50 fällt.

19. Verfahren nach Anspruch 18, wobei die Durchgangsgeschwindigkeit für die gasförmigen Reaktionsbestandteile in dem Bereich von 0,1 bis 2 Liter pro Minute liegt.

FIG. 1

FIG. 2

POWER
SUPPLY

*Fig.* 3

*Fig.* 4

*Fig. 5*

*Fig. 6*